# EUROPEAN PATENT APPLICATION

(11) **EP 4 637 284 A1**
(43) Date of publication of application: **22.10.2025**
(21) Application number: 24217108.0
(22) Date of filing: 03.12.2024
(51) Int. Cl.: H05K 7/20, H02B 1/56, H02S 40/34

(54) **CABINET ASSEMBLY AND PHOTOVOLTAIC POWER STATION**

(30) Priority: 15.04.2024 CN 202420779070 U
(71) Applicant: Sungrow Power Supply Co., Ltd., Hefei, Anhui 230088 (CN)
(72) Inventor: ZHAO, Bo, Hefei, Anhui, 230088 (CN); ZHANG, Xianwei, Hefei, Anhui, 230088 (CN); PAN, Zhiyuan, Hefei, Anhui, 230088 (CN)
(74) Representative: Biallo, Dario

(57) **Abstract**

A cabinet assembly and a photovoltaic power station are provided. The cabinet assembly includes at least one cabinet, a conductive member and a protective hood assembly. The conductive member can be electrically connected to a cabinet output member of the cabinet, and the conductive member is arranged in the protective hood assembly. The protective hood assembly is provided with a first heat dissipation air duct, the cabinet is provided with a second heat dissipation air duct, and the first heat dissipation air duct is in communication with the second heat dissipation air duct of the at least one cabinet to dissipate heat from the conductive member. In this cabinet assembly, a heat dissipation airflow within the second heat dissipation air duct of the cabinet can be utilized to flow through the conductive member within the first heat dissipation air duct for heat dissipation.

## Description

### FIELD

The present application relates to the technical field of power systems, and in particular to a cabinet assembly and a photovoltaic power station.

### BACKGROUND

In a power system of a power station, a cabinet such as a photovoltaic inverter is connected to other apparatus (such as a transformer) by a conductive member.

The conductive member will generate heat during the operation of the cabinet. Natural cooling or forced air cooling can be used to dissipate heat from the conductive member to ensure the normal operation of the cabinet and the conductive member.

In order to improve the heat dissipation effect, forced air cooling is usually adopted to dissipate heat from the conductive member. The forced air cooling requires a fan, and the fan itself and the structural members for mounting the fan lead to an increase in cost.

In summary, a technical problem to be addressed by those skilled in the art is to dissipate heat from the conductive member in order to reduce the heat dissipation cost of the conductive member.

### SUMMARY

In view of this, an object of the present application is to provide a cabinet assembly and a photovoltaic power station to reduce the heat dissipation cost of a conductive member.

In order to achieve the above object, the present application provides the following technical solutions.

A cabinet assembly includes at least one cabinet, a conductive member, and a protective hood assembly, where
the conductive member can be electrically connected to a cabinet output member of the cabinet, and the conductive member is arranged in the protective hood assembly; and
the protective hood assembly is provided with a first heat dissipation air duct, the cabinet is provided with a second heat dissipation air duct, and the first heat dissipation air duct is in communication with the second heat dissipation air duct of the at least one cabinet to dissipate heat from the conductive member.

In an embodiment, a second air inlet of the second heat dissipation air duct is in communication with an external environment, a second air outlet of the second heat dissipation air duct is in communication with a first air inlet of the first heat dissipation air duct, and a first air outlet of the first heat dissipation air duct is in communication with the external environment.

In an embodiment, the second heat dissipation air duct and the first heat dissipation air duct are connected to each other in series.

In an embodiment, the protective hood assembly is located at a bottom end of the cabinet, the second air outlet is located at the bottom end of the cabinet, and the first air inlet is located at a top end of the protective hood assembly.

In an embodiment, the protective hood assembly is located on a lateral face of the cabinet, the second air outlet is located on the lateral face of the cabinet where the protective hood assembly is located, and the first air inlet is located on a lateral face of the protective hood assembly proximate to the cabinet.

In an embodiment, the first air outlet is located on a bottom face or a lateral face of the protective hood assembly.

In an embodiment, the protective hood assembly is located at a bottom end of the cabinet, the second air outlet is located at the bottom end of the cabinet, the first air inlet is located at a top end of the protective hood assembly, and the first air outlet is located on a bottom face or a lateral face of the protective hood assembly.

In an embodiment, the protective hood assembly is located on a lateral face of the cabinet, the second air outlet is located on the lateral face of the cabinet where the protective hood assembly is located, the first air inlet is located on a lateral face of the protective hood assembly proximate to the cabinet, and the first air outlet is located on a bottom face or another lateral face of the protective hood assembly.

In an embodiment, the first air inlet protrudes from the protective hood assembly, and the cabinet is provided with a first recess for accommodating the first air inlet.

In an embodiment, the number of the first air inlet is at least one, and the second heat dissipation air duct corresponds to the at least one first air inlet; and/or, the number of the first air outlet is at least one, and the second heat dissipation air duct corresponds to the at least one first air outlet.

In an embodiment, the number of the cabinet is at least two, and the number of the second heat dissipation air duct is at least two, and the at least two second heat dissipation air ducts correspond to the same first air outlet.

In an embodiment, the number of the cabinet is at least two, and the at least two cabinets are distributed in sequence along a first direction, where the first direction is perpendicular to a vertical direction.

In an embodiment, the cabinet and the protective hood assembly are hermetically connected to each other at a junction between the second heat dissipation air duct and the first heat dissipation air duct.

In an embodiment, the cabinet is provided with a connecting cavity, the connecting cavity and the second heat dissipation air duct are isolated from each other, and the cabinet output member is arranged in the connecting cavity; and
the cabinet assembly further includes an air duct partition configured for isolating the connecting cavity from the first heat dissipation air duct, and the air duct partition is provided with an installation hole for the conductive member or the cabinet output member to pass through.

In an embodiment, the air duct partition and the protective hood assembly are hermetically connected to each other, to isolate the connecting cavity from the first heat dissipation air duct.

In an embodiment, the protective hood assembly is provided with an installation port for the conductive member or the cabinet output member to pass through, and the air duct partition closes the installation port, where
the installation port and a communication port of the first heat dissipation air duct for communicating with the second heat dissipation air duct are distributed in sequence along a first direction, where the first direction is perpendicular to a vertical direction; and/or,
the installation port protrudes from the protective hood assembly, and the cabinet is provided with a second recess for accommodating the installation port.

In an embodiment, the first heat dissipation air duct has a first air outlet communicated with an external environment, and the cabinet assembly further includes a protective mesh provided at the first air outlet.

In an embodiment, the protective mesh is detachably inserted into the protective hood assembly.

In an embodiment, the protective hood assembly is provided with a guide rail, and the protective mesh is in sliding fit with the guide rail; and/or,
the protective mesh is provided with a pluggable limiting member, a plugging and unplugging direction of the pluggable limiting member is perpendicular to an insertion direction of the protective mesh, the protective hood assembly is provided with a limiting hole, and the pluggable limiting member is configured to be in limiting fit with the limiting hole, to limit the protective mesh; and/or,
the protective mesh is detachably connected to the protective hood assembly by a fastener.

In an embodiment, the cabinet assembly further includes a detector configured for detecting whether the protective mesh needs dust removal.

In an embodiment, the detector is provided on the conductive member, and the detector is configured for detecting whether a temperature of the conductive member exceeds a set value, to determine whether the protective mesh needs dust removal; and/or, the cabinet assembly further includes an alarm being in signal connection with the detector.

Based on the above cabinet assembly, a photovoltaic power station is further provided according to the present application. The photovoltaic power station includes a voltage conversion apparatus and the cabinet assembly according to any one of the above solutions, where the conductive member is electrically connected to an input end of the voltage conversion apparatus.

In the cabinet assembly provided according to the present application, the conductive member can be electrically connected to the cabinet output member of the cabinet, the conductive member is provided within the protective hood assembly, the protective hood assembly is provided with the first heat dissipation air duct, the cabinet is provided with the second heat dissipation air duct, and the first heat dissipation air duct is in communication with the second heat dissipation air duct of at least one of the cabinets. In this way, a heat dissipation airflow within the second heat dissipation air duct of the cabinet can be utilized to flow through the conductive member within the first heat dissipation air duct, so that the heat dissipation of the conductive member is realized by means of the heat dissipation airflow within the second heat dissipation air duct of the cabinet. That is to say, the heat dissipation of the conductive member is coupled to the heat dissipation of the cabinet, and there is no need to provide a separate fan to dissipate heat from the conductive member, thereby the cost of the fan itself and the cost required for mounting the fan are reduced, and the heat dissipation cost of the conductive member is also effectively reduced.

Besides, in the cabinet assembly provided according to the present application, the conductive member is forced air-cooled by the forced air cooling heat dissipation of the cabinet, which effectively improves the heat dissipation effect of the conductive member compared to the natural cooling of the conductive member, so that the cross-sectional area of the conductive member can be reduced, and thereby the cost of the conductive member can be greatly reduced.

Moreover, in the cabinet assembly provided according to the present application, the heat dissipation airflow in the second heat dissipation air duct of the cabinet is utilized to dissipate heat from the conductive member. When the cabinet fails, it stops working and the conductive member no longer generates heat, thus the conductive member doesn't need heat dissipation, avoiding the failure of the conductive member due to its inability to dissipate heat effectively, which improves the reliability.

Furthermore, in the cabinet assembly provided according to the present application, in the case that all the second heat dissipation air ducts of the at least two cabinets are in communication with the first heat dissipation air duct, when a part of the cabinets (for example, one of the cabinets) fails, and other cabinets are still in operation, the heat dissipation airflow of the still operating cabinets can flow through the first heat dissipation air duct, to dissipate heat from the conductive member, which can avoid the problem in the prior art that heat of the conductive member cannot be dissipated when the fan separately provided for heat dissipation of the conductive member 3 fails, and thus the reliability of the heat dissipation of the conductive member is improved.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic view showing the structure of a cabinet assembly according to an embodiment of the present application;
FIG. 2 is a schematic view showing the structure of a cabinet assembly according to another embodiment of the present application;
FIG. 3 is a schematic view showing the structure of a cabinet assembly according to another embodiment of the present application;
FIG. 4 shows a heat dissipation state of the cabinet assembly shown in FIG. 3;
FIG. 5 shows another heat dissipation state of the cabinet assembly shown in FIG. 3;
FIG. 6 is a schematic view showing the structure of a cabinet assembly according to another embodiment of the present application;
FIG. 7 is a top view of the structure shown in FIG. 6;
FIG. 8 is a schematic view showing the structure of a cabinet assembly according to another embodiment of the present application;
FIG. 9 is a top view of the structure shown in FIG. 8;
FIG. 10 is a schematic view showing the structure of a cabinet assembly according to another embodiment of the present application;
FIG. 11 is a side view of the structure shown in FIG. 10;
FIG. 12 is a schematic view of a cabinet assembly according to another embodiment of the present application;
FIG. 13 is a schematic view of a cabinet assembly according to another embodiment of the present application;
FIG. 14 is a top view of the structure shown in FIG. 13;
FIG. 15 is a schematic view of a cabinet assembly according to another embodiment of the present application;
FIG. 16 is a top view of a structure of a cabinet assembly according to an embodiment of the present application;
FIG. 17 is a sectional view taken along the line A-A in FIG. 16;
FIG. 18 is an enlarged structural schematic view of a portion B in FIG. 17;
FIG. 19 is an enlarged structural schematic view of a portion C in FIG. 17;
FIG. 20 is a perspective view of a cabinet assembly according to an embodiment of the present application;
FIG. 21 is an enlarged structural schematic view of a portion D in FIG. 20;
FIG. 22 is a perspective view of a cabinet in a cabinet assembly according to an embodiment of the present application;
FIG. 23 is a front view of the cabinet in the cabinet assembly according to the embodiment of the present application;
FIG. 24 is a sectional view taken along the line E-E in FIG. 23;
FIG. 25 is an assembly view of a protective hood assembly and a conductive member in a cabinet assembly according to an embodiment of the present application;
FIG. 26 is an assembly view of a protective hood assembly and a protective mesh in a cabinet assembly according to an the embodiment of the present application;
FIG. 27 is a perspective view of the protective mesh in the cabinet assembly according to the embodiment of the present application; and
FIG. 28 is a partial structural schematic view of a photovoltaic power station according to an embodiment of the present application.

**Reference numerals:**

| | | | |
|---|---|---|---|
| 1 | cabinet, | 11 | second heat dissipation air duct, |
| 12 | connecting cavity, | 13 | cabinet output member, |
| 14 | second air inlet, | 15 | second air outlet, |
| 16 | connecting port, | 17 | recess, |
| 2 | air duct partition, | 3 | conductive member, |
| 31 | connecting section, | 32 | confluence section, |
| 4 | protective hood assembly, | 41 | first heat dissipation air duct, |
| 42 | first air inlet, | 43 | first air outlet, |
| 44 | installation port, | 45 | guide rail, |
| 5 | protective mesh, | 51 | protective mesh main body, |
| 52 | protective mesh frame, | 53 | connecting plate, |
| 54 | connecting hole, | 55 | pluggable limiting member, |
| 6 | integrated platform, | 7 | first sealing member, |
| 8 | second sealing member, | 9 | voltage conversion apparatus. |

### DETAILED DESCRIPTION OF THE EMBODIMENTS

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

The terms used in the following embodiments are only for the purpose of describing particular embodiments and are not intended to limit the present application. As used in the specification and appended claims of the present application, the singular expressions "a", "one", "said", "the above", "the" and "this" are intended to include expressions such as "one or more", unless otherwise indicated clearly in the context. It should also be understood that, in the embodiments of the present application, "one or more" means one, two or more than two.

References to "one embodiment" or "some embodiments" etc. described in this specification indicate one or more embodiments of the present application include a particular feature, structure or characteristic described in conjunction with the embodiment. Therefore, the phrases "in one embodiment", "in some embodiments", "in other embodiments", "in yet other embodiments", etc. appearing in different places in this specification do not necessarily refer to the same embodiment, instead, they mean "one or more but not all embodiments", unless otherwise specifically emphasized in other ways. The terms "include", "comprise", "have" and variations thereof all indicate "include but not limited to", unless otherwise specifically emphasized in other ways.

The term "multiple" in the embodiments of the present application refers to two or more. It should be noted that, in the description of the embodiments of the present application, the terms such as "first", "second" and the like are merely for distinguishing the description, and should not be construed as indicating or implying relative importance or order.

A cabinet assembly and a photovoltaic power station are provided according to an embodiment of the present application, to reduce the heat dissipation cost of a conductive member.

The devices inside an electrical cabinet (referred to as cabinet hereinafter) such as an inverter, a converter, a low-voltage cabinet and a power distribution cabinet generate heat during operation, and the heat inside the cabinet needs to be removed. Forced air cooling is adopted in the cabinet to dissipate heat, i.e., external air is sucked into the cabinet, and the airflow cools the internal devices and then is discharged from the cabinet. Based on this, according to the present application, the heat dissipation airflow discharged from the cabinet is used to cool a conductive member, so as to reduce the cooling cost of the conductive member.

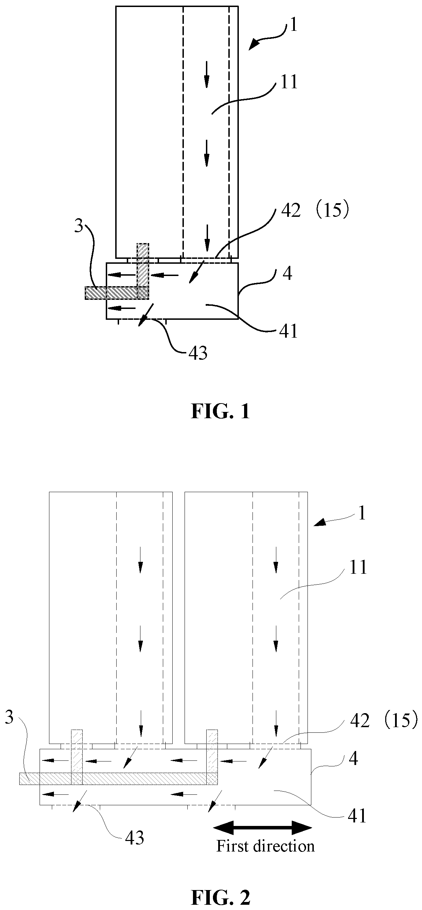

As shown in FIG. 1-FIG. 3, a cabinet assembly according to an embodiment of the present application includes at least one cabinet 1, a conductive member 3, and a protective hood assembly 4.

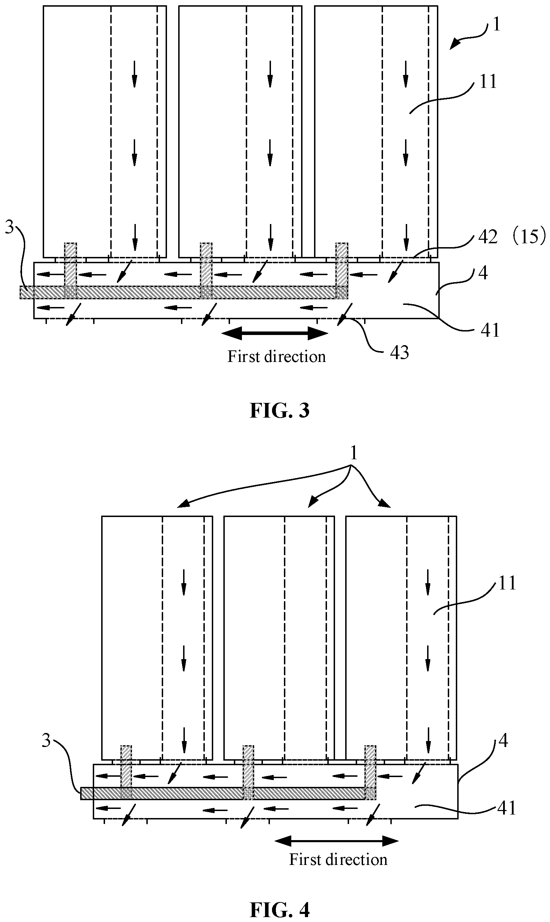

As shown in FIG. 1, one cabinet 1 is provided; as shown in FIG. 2, two cabinets 1 are provided; as shown in FIG. 3, three cabinets 1 are provided. In practice, the number of the cabinets 1 may be four, five, six or more, and the number of the cabinets 1 is not limited in this embodiment.

Each cabinet 1 is provided with a second heat dissipation air duct 11. It should be noted that the cabinet 1 may include a fan (not shown in the figures) for driving air to flow through the second heat dissipation air duct 11, i.e., the second heat dissipation air duct 11 is used for forced air cooling. The fan can be provided outside or inside the second heat dissipation air duct 11, and the fan may be proximate to an air inlet or an air outlet of the second heat dissipation air duct 11. The air inlet of the second heat dissipation air duct 11 is called a second air inlet 14, and the air outlet of the second heat dissipation air duct 11 is called a second air outlet 15. At least one of the second air inlet 14 and the second air outlet 15 is in communication with the external environment. The external environment refers to the external environment of the cabinet 1 and the protective hood assembly 4.

The arrangement, number and type of the fan may be determined according to the actual situation, which are not limited in this embodiment.

The second heat dissipation air duct 11 is located inside the cabinet 1, and the specific structure and shape of the second heat dissipation air duct 11 may be determined according to the actual situation, which are not limited in this embodiment.

Each cabinet 1 is also provided with a cabinet output member 13, and the conductive member 3 can be electrically connected to the cabinet output member 13.

It should be noted that, when the cabinet 1 is required to work, the conductive member 3 is electrically connected to the cabinet output member 13; and when the cabinet 1 is not required to work, the conductive member 3 may be electrically connected to an output member of other apparatus or may not be electrically connected to the output member of any apparatus.

The cabinet output member 13 may be a copper busbar, an aluminum busbar or a copper-aluminum busbar. The conductive member 3 may be a busbar, such as a copper busbar, an aluminum busbar or a copper-aluminum busbar, etc. The specific structures of the cabinet output member 13 and the conductive member 3 are not limited in this embodiment.

The electrical connection mode between the cabinet output member 13 and the conductive member 3 is selected according to the actual situation, which is not limited in this embodiment.

When there are at least two cabinets 1, the cabinet output members 13 of the at least two cabinets 1 may be electrically connected to the conductive member 3. In this case, the conductive member 3 realize the confluence of the at least two cabinets 1.

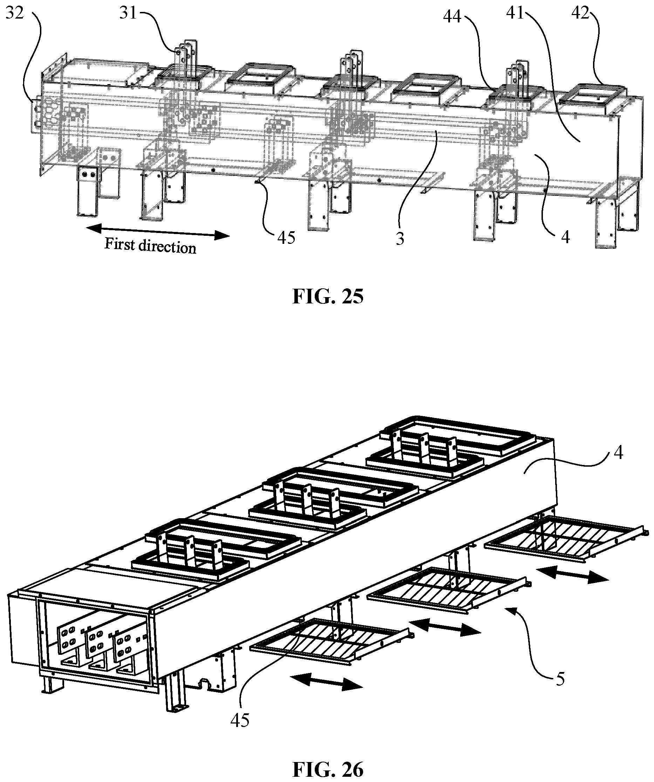

In the case that the conductive member 3 has the confluence function, as shown in FIG. 25, the conductive member 3 includes multiple connecting sections 31 and a confluence section 32, one end of each of the connecting sections 31 is electrically connected to the corresponding cabinet output member 13, and the other end of the connecting section 31 is electrically connected to the confluence section 32. The confluence section 32 may be a single component, or may include multiple confluence portions electrically connected to each other in sequence.

When there are at least two cabinets 1, as shown in FIG. 2 and FIG. 3, the at least two cabinets 1 may be sequentially distributed in a first direction, where the first direction is a left-right direction in FIG. 2 and FIG. 3. The first direction is perpendicular to a vertical direction, and the first direction may be a confluence direction of the conductive members 3, where the confluence direction may be understood as a length direction of the confluence section 32. The above arrangement makes the confluence and installation convenient.

The conductive member 3 is arranged in the protective hood assembly 4, and the protective hood assembly 4 is provided with a first heat dissipation air duct 41. It should be noted that at least part of the conductive member 3 is located within the first heat dissipation air duct 41.

The first heat dissipation air duct 41 is in communication with the second heat dissipation air duct 11 of the at least one cabinet 1 to dissipate heat from the conductive member 3. In this embodiment, when the second heat dissipation air duct 11 is used for forced air cooling, the first heat dissipation air duct 41 is also used for forced air cooling, i.e., the fan of the cabinet 1 is used for driving air to flow through the second heat dissipation air duct 11 and the first heat dissipation air duct 41.

Exemplarily, in a case that three cabinets are provided, the first heat dissipation air duct 41 is in communication with a second heat dissipation air duct 11 of one of the cabinets 1; or, the first heat dissipation air duct 41 is in communication with second heat dissipation air ducts 11 of two of the cabinets 1; or, the first heat dissipation air duct 41 is in communication with second heat dissipation air ducts 11 of all the three cabinets 1.

In the cabinet assembly according to the above embodiment, the conductive member 3 can be electrically connected to the cabinet output member 13 of the cabinet 1, the conductive member 3 is arranged within the protective hood assembly 4, and the protective hood assembly 4 is provided with the first heat dissipation air duct 41; the cabinet 1 is provided with the second heat dissipation air duct 11, and the first heat dissipation air duct 41 is in communication with the second heat dissipation air duct 11 of at least one cabinet 1 to dissipate heat from the conductive member 3. In this way, the heat dissipation airflow from the second heat dissipation air duct 11 in the cabinet 1 may be utilized to flow through the conductive member 3 in the first heat dissipation air duct 41, so that the heat dissipation of the conductive member 3 is realized by means of the heat dissipation airflow from the second heat dissipation air duct 11 in the cabinet 1. That is to say, the heat dissipation of the conductive member 3 and the heat dissipation of the cabinet 1 are coupled, and there is no need to provide a separate fan to dissipate heat from the conductive member 3, thereby the cost of the fan itself and the cost required for mounting the fan are reduced, and the heat dissipation cost of the conductive member 3 is also effectively reduced.

In the cabinet assembly according to the above embodiment, the conductive member 3 is forced air-cooled by the forced air cooling heat dissipation of the cabinet 1, which effectively improves the heat dissipation effect of the conductive member 3 compared to the natural cooling of the conductive member 3.

A maximum current that the conductive member 3 can carry is related to a temperature of the conductive member 3. If the temperature of the conductive member 3 is high, the maximum current that the conductive member 3 can carry is small; and if the temperature of the conductive member 3 is low, the maximum current that the conductive member 3 can carry is large. The maximum current that the conductive member 3 can carry is also related to a cross-sectional area of the conductive member 3. The larger the cross-sectional area of the conductive member 3 is, the greater the maximum current that the conductive member 3 can carry; and the smaller the cross-sectional area of the conductive member 3 is, the smaller the maximum current that the conductive member 3 can carry. As mentioned above, the cabinet assembly improves the heat dissipation effect of the conductive member 3, reducing the temperature of the conductive member 3. As a result, the maximum current that the conductive member 3 can carry is increased. Thus, the cross-sectional area of the conductive member 3 can be reduced, and thereby the cost of the conductive member 3 is also reduced.

Moreover, in the cabinet assembly according to the present application, the heat dissipation airflow from the second heat dissipation air duct 11 in the cabinet 1 is used to dissipate heat from the conductive member 3. When the cabinet 1 fails, it stops working and the conductive member 3 no longer generates heat, thus the conductive member 3 doesn't need heat dissipation, avoiding the failure of the conductive member 3 due to its inability to dissipate heat effectively, which improves the reliability.

In the forced air cooling in the prior art, the conductive member is arranged in a cavity, and the fan dissipates heat from the conductive member. When the fan does not work due to a failure, the conductive member continues to generate heat, leading to the failure of the conductive member due to its inability to dissipate heat effectively, and the reliability is low. Based on this, in the cabinet assembly according to the embodiment of the present application, the second heat dissipation air ducts 11 of at least two cabinets 1 are both in communication with the first heat dissipation air duct 41. In this way, when some of the cabinets 1 (for example, one cabinet 1) fails to work, and other cabinets 1 are still in operation, the heat dissipation airflow of the still operating cabinets 1 can flow through the first heat dissipation air duct 41, to dissipate heat from the conductive member 3.

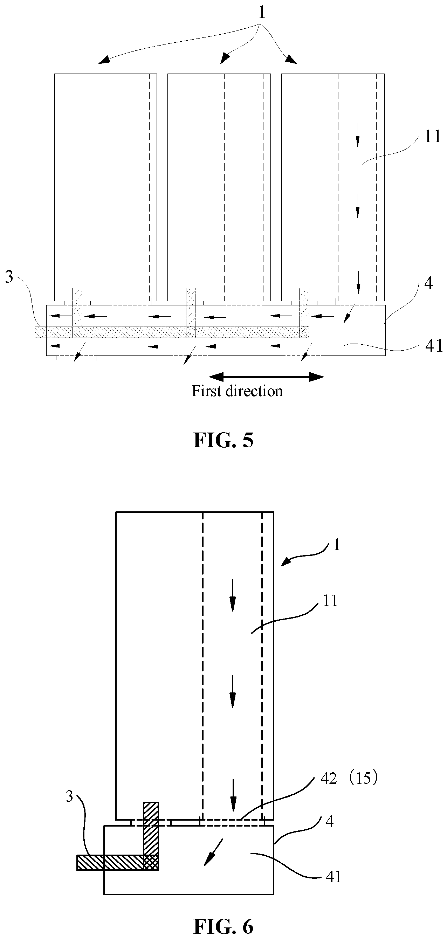

Exemplarily, as shown in FIG. 4, there are three cabinets 1, distributed in sequence along the first direction, i.e., distributed in sequence along the left-right direction. The cabinet 1 located in the middle fails to work, the fan of this cabinet 1 does not work, and there is no heat dissipation airflow in the second heat dissipation air duct 11. The cabinet 1 on the left and the cabinet 1 on the right work normally, and the fans of these two cabinets 1 also work normally. There is heat dissipation airflow in the second heat dissipation air ducts 11 of these two cabinets 1, and the heat dissipation airflow will enter the first heat dissipation air duct 41 to dissipate heat from the conductive member 3. As shown in fig. 5, there are three cabinets 1, distributed in sequence along in the first direction, i.e., distributed in sequence along the left-right direction. The cabinets 1 on the left and in the middle fail to work, the fans of the cabinets 1 do not work, and there is no heat dissipation air flow in the second heat dissipation air ducts 11; the cabinet 1 on the right works normally, and the fan of this cabinet 1 also works normally. There is heat dissipation airflow in the second heat dissipation air duct 11 of the cabinet 1 on the right, and the heat dissipation airflow will enter the first heat dissipation air duct 41 to dissipate heat from the conductive member 3.

Therefore, the cabinet assembly according to the above embodiment can avoid the problem in the prior art that heat of the conductive member 3 cannot be dissipated when the fan separately provided for heat dissipation of the conductive member 3 fails, and thus the reliability of the heat dissipation of the conductive member 3 is improved.

In the embodiment of the present application, the second heat dissipation air duct 11 has a second air inlet 14 and a second air outlet 15, and both the second air inlet 14 and the second air outlet 15 are in communication with the external environment. The specific positions of the second air inlet 14 and the second air outlet 15 on the cabinet 1 can be provided according to the actual situation, for example, the second air inlet 14 is located on a top surface or a side of the cabinet 1, and the second air outlet 15 is located on the bottom surface or a side of the cabinet 1, etc., which is not limited in the present embodiment.

In some embodiments, both the second air inlet 14 and the second air outlet 15 of the second heat dissipation air duct 11 are in communication with the external environment, and a first air inlet 42 and a first air outlet 43 of the first heat dissipation air duct 41 are both in communication with the second heat dissipation air duct 11.

In some other embodiments, the second air inlet 14 of the second heat dissipation air duct 11 is in communication with the external environment, the second air outlet 15 of the second heat dissipation air duct 11 is in communication with the first air inlet 42 of the first heat dissipation air duct 41, and the first air outlet 43 of the first heat dissipation air duct 41 is in communication with the external environment. In this case, the second air outlet 15 is in communication with the external environment via the first heat dissipation air duct 41.

In the above embodiment, air from the external environment enters the second heat dissipation air duct 11 via the second air inlet 14, then enters the first heat dissipation air duct 41 via the second air outlet 15 and the first air inlet 42, and finally is discharged from the first air outlet 43.

In the above embodiment, the second heat dissipation air duct 11 and the first heat dissipation air duct 41 are connected in series. It should be noted that the second heat dissipation air duct 11 is located upstream of the first heat dissipation air duct 41 in an airflow direction. Alternatively, one portion of the second heat dissipation air duct 11 is connected with the first heat dissipation air duct 41 in series, and the other portion of the second heat dissipation air duct 11 and the first heat dissipation air duct 41 are embodied as two branches.

In some embodiments, the protective hood assembly 4 may be located at a bottom end of the cabinet 1, the second air outlet 15 is located at the bottom end of the cabinet 1, and the first air inlet 42 is located at a top end of the protective hood assembly 4. In this way, it is convenient for the second heat dissipation air duct 11 to be communicated with the first heat dissipation air duct 41, and it is also convenient for the cabinet output member 13 to be electrically connected to the conductive member 3.

In some other embodiments, the protective hood assembly 4 may be located on a lateral face of the cabinet 1, the second air outlet 15 is located on the lateral face of the cabinet 1 where the protective hood assembly 4 is located, and the first air inlet 42 is located on a lateral face of the protective hood assembly 4 proximate to the cabinet 1. In this way, a height of the whole cabinet assembly is reduced, and the communication between the second heat dissipation air duct 11 and the first heat dissipation air duct 41 is facilitated.

It should be noted that lateral faces of the cabinet 1 refer to the faces of the cabinet 1 other than its top end (i.e., top face) and bottom end (i.e., bottom face). Lateral faces of the protective hood assembly 4 refer to the faces of the protective hood assembly 4 other than its top end (i.e., top face) and bottom end (i.e., bottom face).

In some embodiments, the first air outlet 43 is located on a bottom face or a lateral face of the protective hood assembly 4, so as to discharge the airflow.

In practice, the relative positions of the protective hood assembly 4 and the cabinet 1 and the position of the first air outlet 43 on the protective hood assembly 4 may be arbitrarily arranged, as long as the heat dissipation and electrical connection are ensured.

As shown in FIG. 1 to FIG. 5, the protective hood assembly 4 is located at the bottom end of the cabinet 1, the second air outlet 15 is located at the bottom end of the cabinet 1, the first air inlet 42 is located at the top end of the protective hood assembly 4, and the first air outlet 43 is located on the bottom face of the protective hood assembly 4.

As shown in FIG. 6 to FIG. 9, the protective hood assembly 4 is located at the bottom end of the cabinet 1, the second air outlet 15 is located at the bottom end of the cabinet 1, the first air inlet 42 is located at the top end of the protective hood assembly 4, and the first air outlet 43 is located on a lateral face of the protective hood assembly 4.

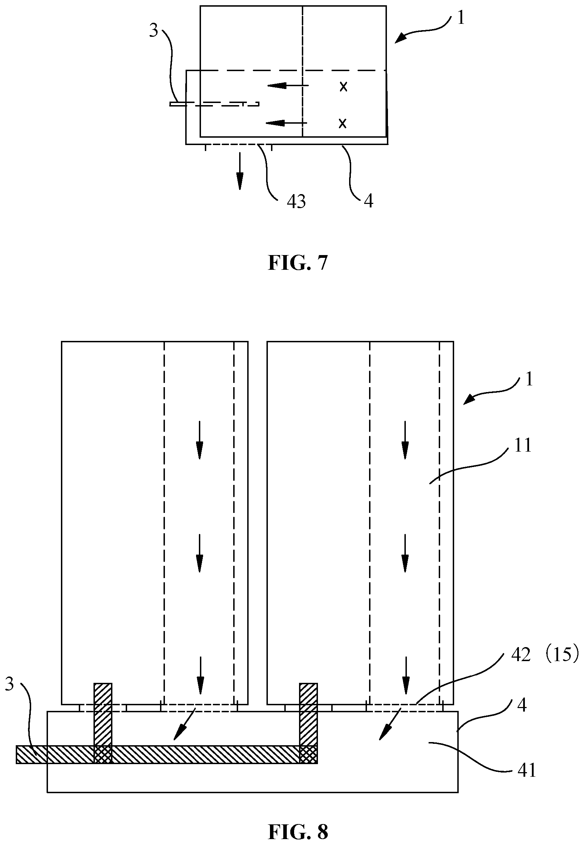

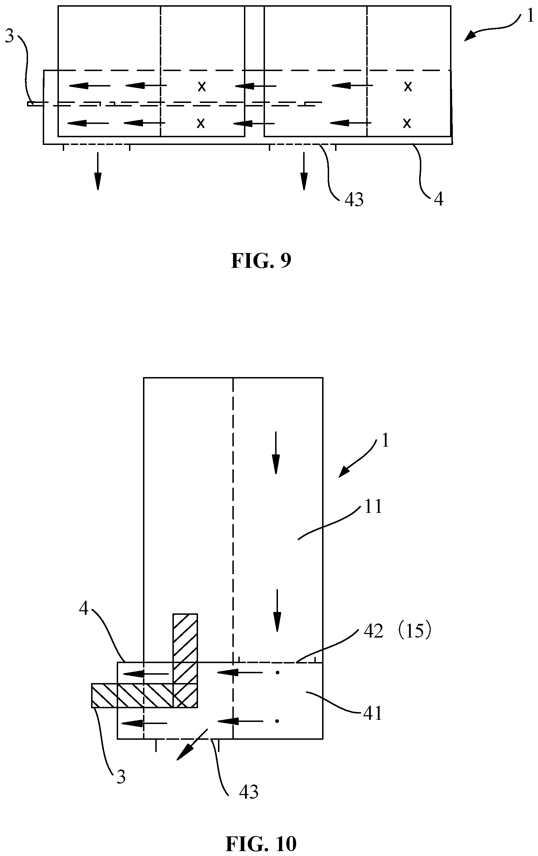

It should be noted that FIG. 6 and FIG. 7 show the case that there is only one cabinet 1, and FIG. 8 and FIG. 9 show the case that there are two cabinets 1. A symbol "×" shown in FIG. 7 and FIG. 9 indicates that the airflow direction is perpendicular to the paper surface and points into the paper.

As shown in FIG. 10 to FIG. 12, the protective hood assembly 4 is located on a lateral face of the cabinet 1, the second air outlet 15 is located on the lateral face of the cabinet 1 where the protective hood assembly 4 is located, the first air inlet 42 is located on a lateral face of the protective hood assembly 4 proximate to the cabinet 1, and the first air outlet 43 is located on a bottom face of the protective hood assembly 4.

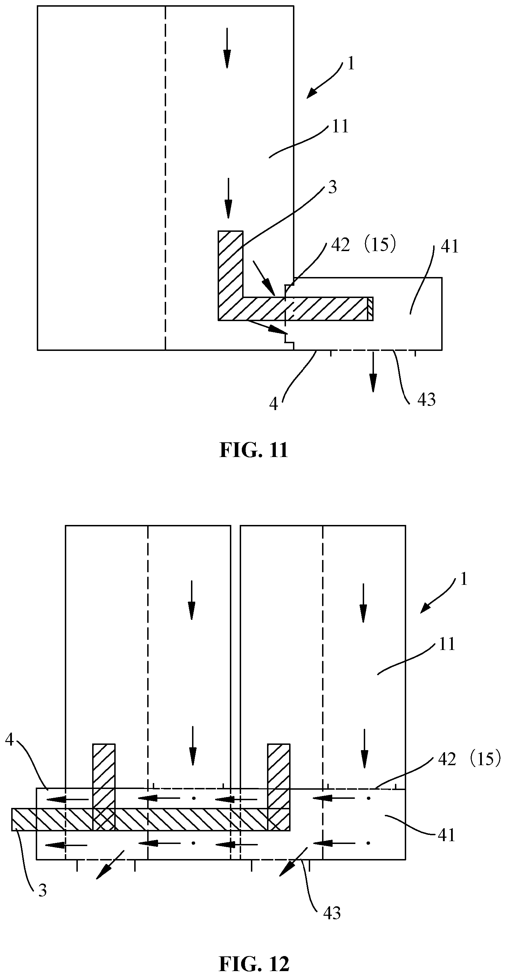

It should be noted that FIG.10 and FIG. 11 show the case that there is only one cabinet 1, and FIG. 12 shows the case that there are two cabinets 1. The side view of the structure shown in FIG. 12 is the same as that of FIG. 11. A symbol " • " shown in FIG. 10 and FIG. 12 indicates that the airflow direction is perpendicular to the paper surface and points out of the paper.

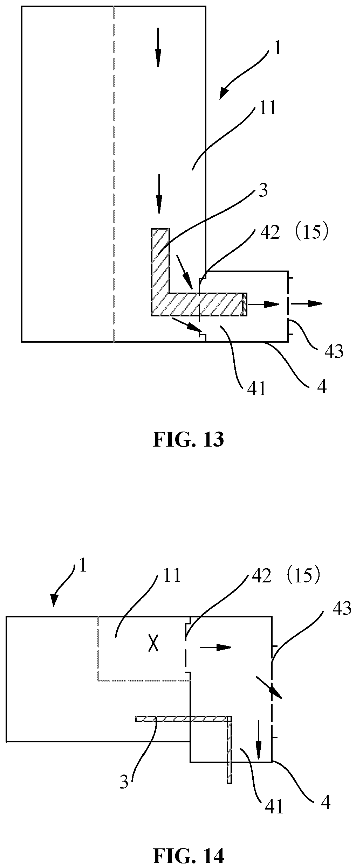

As shown in FIG. 13 to FIG. 15, the protective hood assembly 4 is located on a lateral face of the cabinet 1, the second air outlet 15 is located on the lateral face of the cabinet 1 where the protective hood assembly 4 is located, the first air inlet 42 is located on a lateral face of the protective hood assembly 4 close to the cabinet 1, and the first air outlet 43 is located on another lateral face of the protective hood assembly 4. It should be noted that the first air outlet 43 is located on the another lateral face of the protective hood assembly 4 away from the cabinet 1.

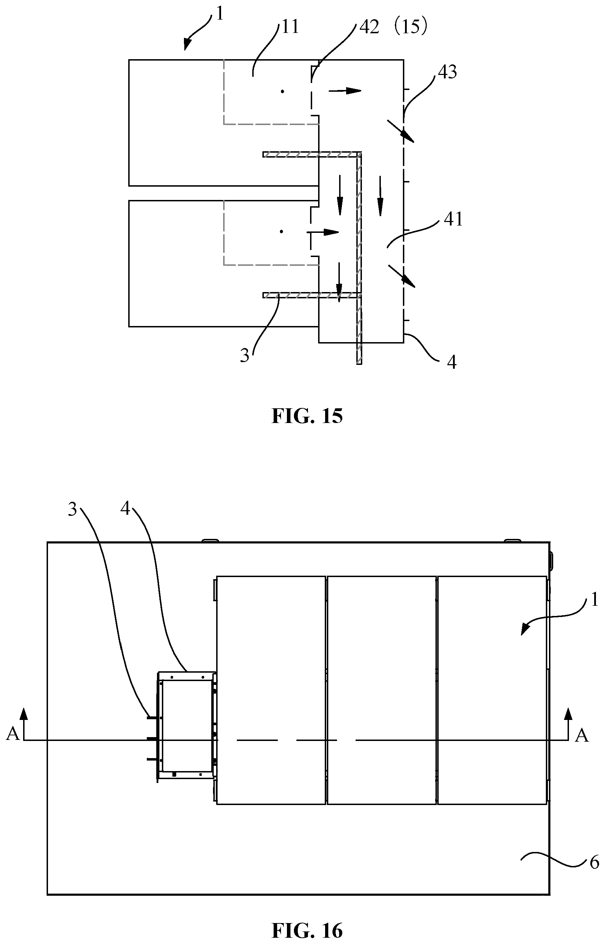

It should be noted that FIG. 13 and FIG. 14 show the case that there is only one cabinet 1, and FIG. 15 shows the case that there are two cabinets 1. A symbol "×" shown in FIG. 14 indicates that the airflow direction is perpendicular to the paper surface and points into the paper. A symbol " • " shown in FIG. 15 indicates that the airflow direction is perpendicular to the paper surface and points out of the paper.

In an embodiment of the present application, the first air inlet 42 of the first heat dissipation air duct 41 is connected and communicated with the second air outlet 15 of the second heat dissipation air duct 11. In FIG. 1 to FIG. 15, an indication line labeled with "42(15)" is directed to a position where both the first air inlet 42 and the second air outlet 15 are located.

In the embodiment of the present application, the specific position of the second air inlet 14 of the second heat dissipation air duct 11 is selected according to the actual situation, which will not be limited in this embodiment.

In order to facilitate the communication between the first air inlet 42 and the second air outlet 15, the first air inlet 42 may protrude from the protective hood assembly 4, and the cabinet 1 is provided with a first recess for accommodating the first air inlet 42. In this way, the first recess and the protruding first air inlet 42 are mutually limited, thus simplifying the installation of the protective hood assembly 4 and the cabinet 1, and also facilitating the communication between the first air inlet 42 and the second air outlet 15.

In practice, the cabinet assembly may not be provided with the above limiting structure, which is not limited to the above embodiments.

In the embodiment of the present application, the cabinet 1 has at least one second heat dissipation air duct 11. The first air inlet 42 of the first heat dissipation air duct 41 is at least one, and the at least one second heat dissipation air duct 11 corresponds to the at least one first air inlet 42. In order to simplify the structure, the at least one second heat dissipation air duct 11 may be in one-to-one correspondence with the at least one first air inlet 42 In this case, each cabinet 1 may have one second heat dissipation air duct 11, and any two of the first air inlets 42 are sequentially distributed along a distribution direction of any two of the cabinets 1. Of course, the first air inlet 42 of the first heat dissipation air duct 41 may be only one, and all the second heat dissipation air ducts 11 are communicated with the same first air inlet 42.

In an embodiment of the present application, the first air outlet 43 of the first heat dissipation air duct 41 is at least one. In order to improve the efficiency of the airflow discharging to the external environment to improve the heat dissipation effect, the second heat dissipation air duct 11 may correspond to the at least one first air outlet 43. In order to simplify the structure, the second heat dissipation air duct 11 may in one-to-one correspondence to the at least one first air outlet 43 In this case, each cabinet 1 may have one second heat dissipation air duct 11, and any two of the first air outlets 43 are sequentially distributed along a distribution direction of any two of the cabinets 1.

When there are at least two cabinets 1, there are at least two second heat dissipation air ducts 11, and the at least two second heat dissipation air ducts 11 may correspond to the same first air outlet 43. Based on this, the first air outlet 43 of the first heat dissipation air duct 41 may be only one, and all the airflow is discharged to the external environment only via the first air outlet 43.

In an embodiment of the present application, in order to improve the heat dissipation effect of the conductive member 3, the cabinet 1 and the protective hood assembly 4 may be hermetically connected to each other at a junction between the second heat dissipation air duct 11 and the first heat dissipation air duct 41. In this way, air leakage is avoided, and the heat dissipation effect of the conductive member 3 is improved. The sealing structure between the cabinet 1 and the protective hood assembly 4 may be selected according to the actual situation, for example, the sealing is realized by a sealant, or a sealing member such as a sealing rubber strip or a sealing ring, which is not limited in this embodiment.

Exemplarily, as shown in FIG. 16 to FIG. 18, a first sealing member 7 is provided at the first air inlet 42 of the protective hood assembly 4, and the protective hood assembly 4 is hermetically connected to the cabinet 1 through the first sealing member 7, i.e., the protective hood assembly 4 is hermetically connected to the cabinet 1 at the junction between the second heat dissipation air duct 11 and the first heat dissipation air duct 41 through the first sealing member 7. Exemplarily, the first sealing member 7 is a sealing rubber strip, and the protective hood assembly 4 and the cabinet 1 are sealed by the compression of the sealing rubber strip.

In an embodiment of the present application, the cabinet output member 13 may be arranged inside or outside the second heat dissipation air duct 11. Correspondingly, an electrical connecting position between the cabinet output member 13 and the conductive member 3 may be inside or outside the heat dissipation air duct (the first heat dissipation air duct 41 or the second heat dissipation air duct 11).

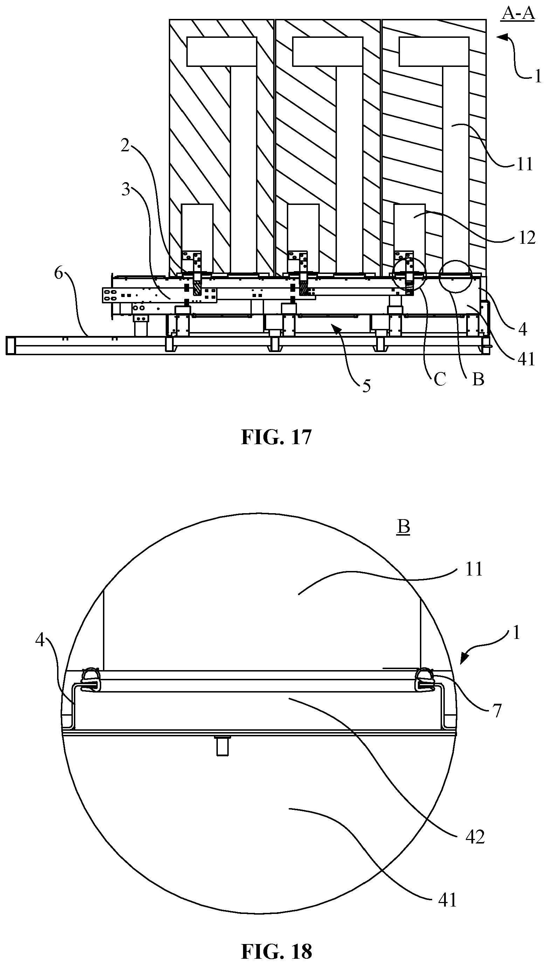

In an embodiment of the present application, as shown in FIG. 16 and FIG. 17, the cabinet 1 and the protective hood assembly 4 can be integrated on an integration platform 6 in order to improve the integration. Of course, the cabinet 1 and the protective hood assembly 4 may be provided on different platforms respectively, which is not limited to the above structure.

In order to avoid the influence of the heat dissipation airflow on the electrical connection and improve the reliability and protective performance of the electrical connection, the cabinet output member 13 may be arranged outside the second heat dissipation air duct 11. As shown in FIG. 16 to FIG. 24, in some embodiments, the cabinet 1 is provided with a connecting cavity 12, the connecting cavity 12 and the second heat dissipation air duct 11 are isolated from each other, and the cabinet output member 13 is arranged in the connecting cavity 12.

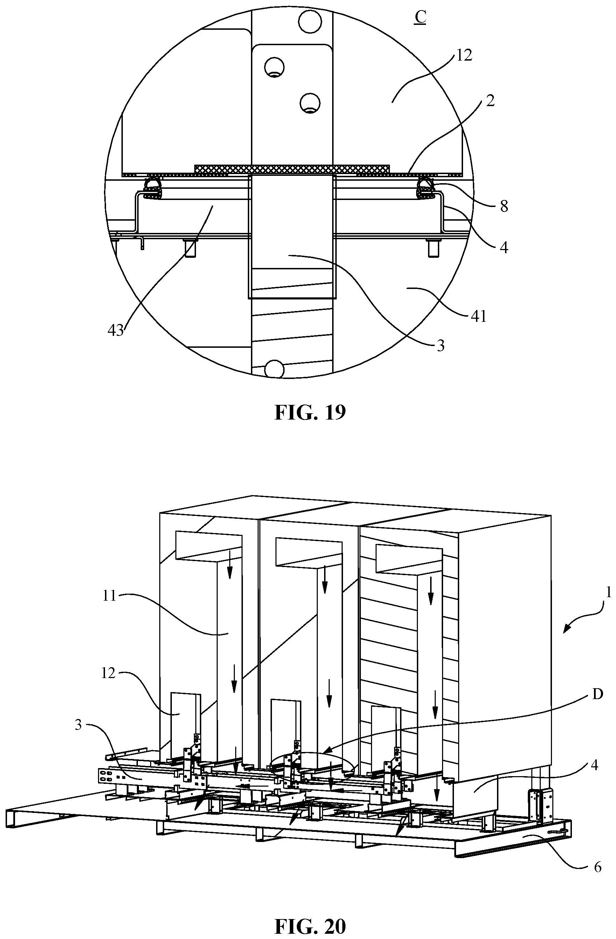

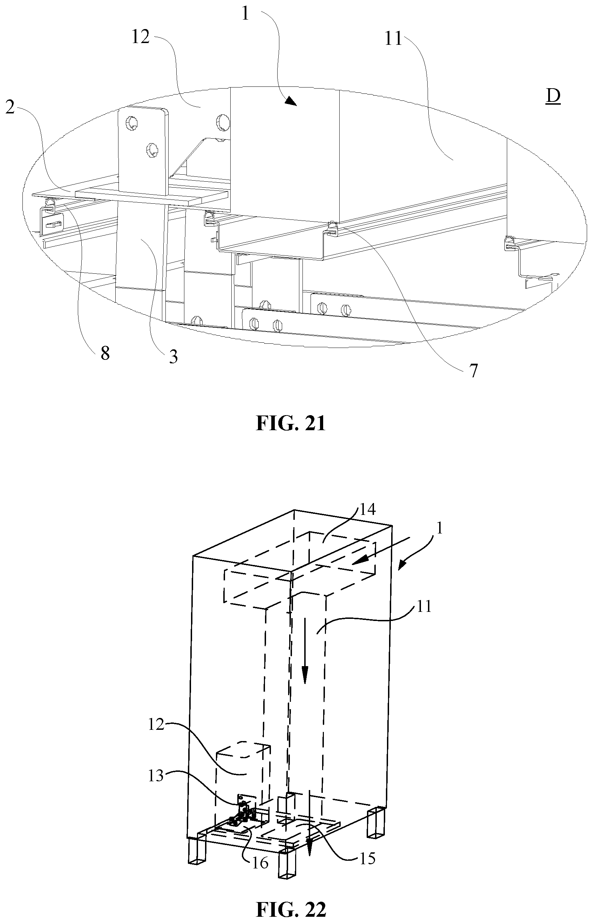

As shown in FIG. 19 and FIG. 21, the cabinet assembly further includes an air duct partition 2, which isolates the connecting cavity 12 from the first heat dissipation air duct 41. In this way, the heat dissipation airflow is prevented from entering the connecting cavity 12.

The air duct partition 2 can be understood as part of the cabinet 1. In this case, the air duct partition 2 and the protective hood assembly 4 are hermetically connected to each other in order to ensure that the air duct partition 2 isolates the connecting cavity 12 from the first heat dissipation air duct 41. In some embodiments, the protective hood assembly 4 is provided with a second sealing member 8, and the air duct partition 2 is hermetically connected to the protective hood assembly 4 through the second sealing member 8. Exemplarily, the second sealing member 8 is a sealing rubber strip, and the protective hood assembly 4 and the air duct partition 2 are sealed by the compression of the sealing rubber strip.

In some other embodiments, the air duct partition 2 may also be hermetically connected to the protective hood assembly 4 in other manners, which is not limited to the above embodiments.

The air duct partition 2 can also be understood as part of the protective hood assembly 4. In this case, the air duct partition 2 and the cabinet 1 are hermetically connected to each other in order to ensure that the air duct partition 2 isolates the connecting cavity 12 from the first heat dissipation air duct 41. The sealing structure between the air duct partition 2 and the cabinet 1 can be selected according to the actual situation, which is not limited in this embodiment.

The air duct partition 2 is provided with an installation hole for the conductive member 3 to pass through, i.e., the connection cavity 12 has a connecting port 16 for the conductive member 3 to pass through. In this way, the cabinet output member 13 and the conductive member 3 are electrically connected to each other within the connecting cavity 12. Alternatively, the air duct partition 2 is provided with an installation hole for the cabinet output member 13 to pass through, i.e., the connection cavity 12 has a connecting port 16 for the cabinet output member 13 to pass through. In this way, the cabinet output member 13 and the conductive member 3 are electrically connected to each other within the first heat dissipation air duct 41.

In an embodiment of the present application, the protective hood assembly 4 is provided with an installation port 44. In a case that the installation hole of the air duct partition 2 is configured for the conductive member 3 to pass through, the installation port 44 is used for the conductive member 3 to pass through. In a case that the installation hole of the air duct partition 2 is configured for the cabinet output member 13 to pass through, the installation port 44 is used for the cabinet output member 13 to pass through. The air duct partition 2 closes the installation port 44.

As shown in FIG. 25, the above installation port 44 and the communication port (the first air inlet 42) of the first heat dissipation air duct 41 for communicating with the second heat dissipation air duct 11 are sequentially distributed in the first direction, where the first direction is perpendicular to the vertical direction. When there are at least two cabinets 1, the first direction is the direction in which any two of the cabinets 1 are sequentially distributed.

The installation port 44 protrudes from the protective hood assembly 4, and the cabinet 1 is provided with a second recess which accommodates the installation port 44. In this way, the second recess and the installation port 44 are mutually limited, thus facilitating the installation of the cabinet 1 and the protective hood assembly 4.

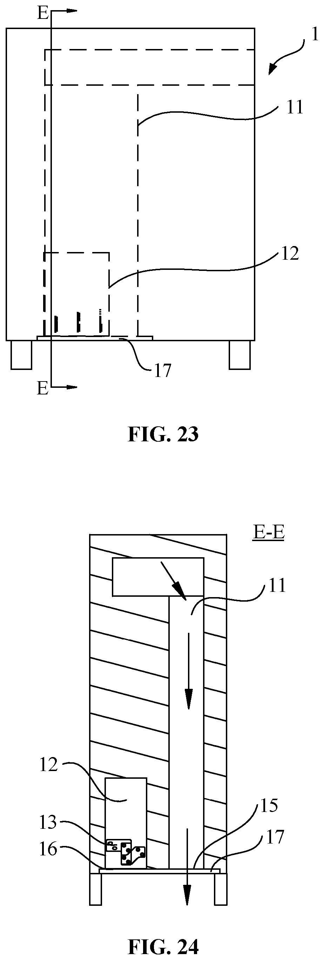

When the cabinet 1 is provided with a first recess, the first recess and the second recess may be embodied as the same recess 17, as shown in FIG. 23. Of course, the first recess and the second recess may be different recesses.

In an embodiment of the present application, in the case that the first heat dissipation air duct 41 has a first air outlet 43 communicated with the external environment, as shown in FIG. 17 and FIG. 26, the cabinet assembly further includes a protective mesh 5 provided at the first air outlet 43, so that foreign matters are prevented from entering the first heat dissipation air duct 41 via the first air outlet 43, and thus the protective performance of the whole cabinet assembly is improved.

After the protective mesh 5 has been used for a period of time, there are many foreign matters such as dust on the protective mesh 5, so it is necessary to clean the protective mesh 5 regularly. In order to facilitate the cleaning and replacement of the protective mesh 5, the protective mesh 5 is detachably connected to the protective hood assembly 4. The specific mode of detachable fixing connection may be selected according to the actual situation, for example, the detachable fixing connection is realized by means of a fastener, a snap-in structure, etc., which is not limited in this embodiment.

In order to facilitate the maintenance of the protective mesh 5, the protective mesh 5 can be detachably inserted into the protective hood assembly 4.

The above protective hood assembly 4 is provided with a guide rail 45, and the protective mesh 5 is in sliding fit with the guide rail 45, which facilitate the mounting of the protective mesh 5. It should be noted that the sliding direction of the protective mesh 5 on the guide rail 45 is the insertion direction of the protective mesh 5.

In order to improve the stability of the protective mesh 5, the protective mesh 5 is provided with a pluggable limiting member 55, the plugging and unplugging direction of the pluggable limiting member 55 is perpendicular to the insertion direction of the protective mesh 5. The protective hood assembly 4 is provided with a limiting hole, and the pluggable limiting member 55 is configured to be in limiting fit with the limiting hole so as to limit the protective mesh 5. In this way, that limiting fit between the protective mesh 5 and the protective hood assembly 4 is realized, and the limiting fit is detachable.

The pluggable limiting member 55 may be distributed around the protective mesh 5, alternatively, the pluggable limiting member 55 may be distributed at an outer end of the protective mesh 5 in the insertion direction.

The pluggable limiting member 55 may be a spring pin or other structure, which is not limited in this embodiment.

The protective mesh 5 is mounted without screws, so it is beneficial for the maintenance, which improves the maintenance efficiency and reduce the use of tools.

In practice, the protective mesh 5 may also be detachably connected to the protective hood assembly 4 by a fastener. Moreover, the pluggable limiting member 55 may be used together with the fastener.

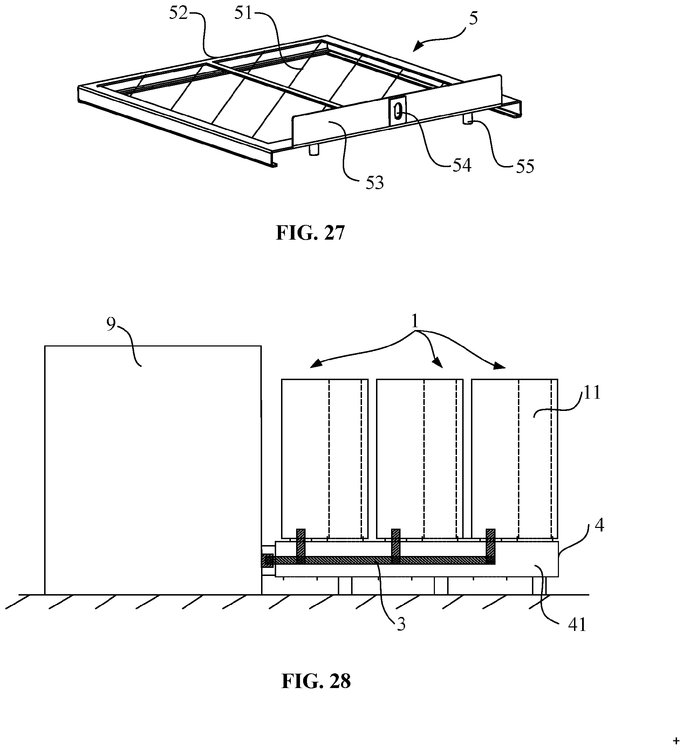

As shown in FIG. 27, in some embodiments, the protective mesh 5 includes a protective mesh main body 51 and a protective mesh frame 52 provided at a periphery of the protective mesh main body 51. The protective mesh frame 52 and the protective hood assembly 4 are detachably connected to each other.

In order to facilitate the fixing connection between the protective mesh frame 52 and the protective hood assembly 4, the protective mesh frame 52 is provided with a connecting plate 53, which is detachably connected to the protective hood assembly 4.

The connecting plate 53 may be perpendicular to the protective mesh frame 52, parallel to the protective mesh frame 52, or inclined relative to the protective mesh frame 52. In order to fix the protective mesh 5, the connecting plate 53 is perpendicular to the protective mesh frame 52, and the connecting plate 53 is detachably connected to the protective hood assembly 4 by a fastener.

It should be noted that the connecting plate 53 is provided with a connecting hole 54 for the fastener to pass through, and the protective hood assembly 4 is provided with a fixing hole for fixing the fastener.

In a case that the protective mesh 5 is in limiting fit with the protective hood assembly 4, the pluggable limiting member 55 can be provided on the protective mesh frame 52.

Exemplarily, the first air outlet 43 is located on the bottom face of the protective hood assembly 4, the insertion direction of the protective mesh 5 is in a horizontal direction, the protective mesh 5 is in sliding fit with the guide rail 45 in a direction perpendicular to the vertical direction, and the protective mesh frame 52 is in limiting fit with the protective hood assembly 4 in the vertical direction. Alternatively, the first air outlet 43 is located on the lateral face of the protective hood assembly 4, the insertion direction of the protective mesh 5 is in the vertical direction, the protective mesh 5 is in sliding fit with the guide rail 45 in the vertical direction, and the protective mesh frame 52 is in limiting fit with the protective hood assembly 4 in a direction perpendicular to the vertical direction.

In some embodiments, the cabinet assembly further includes a detector configured for detecting whether the protective mesh 5 needs dust removal.

The above detector may be a temperature detector, which is configured for detecting whether a temperature of the conductive member 3 exceeds a set value (a first set value), so as to determine whether the protective mesh 5 needs dust removal. In this case, the detector is arranged on the conductive member 3. In the case that the conductive member 3 includes the connecting section 31 and the confluence section 32, the detector is arranged on the confluence section 32. Of course, the detector may be arranged on a portion of the connecting section 31 that is located within the first heat dissipation air duct 41.

It should be noted that if it is detected that the temperature of the conductive member 3 exceeds the first set value, it is determined that the protective mesh 5 needs dust removal; and if it is detected that the temperature of the conductive member 3 does not exceed the first set value, it is determined that the protective mesh 5 does not need dust removal.

The above detector may also be a flow sensor, which is configured for detecting whether a flow at the first air outlet 43 is less than a second set value, so as to determine whether the protective mesh 5 needs dust removal. The detector may be arranged inside or outside the first heat dissipation air duct 41.

It should be noted that if it is detected that the flow at the first air outlet 43 is less than the second set value, it is determined that the protective mesh 5 needs dust removal; and if it is detected that the flow at the first air outlet 43 is not less than the second set value, it is determined that the protective mesh 5 does not need dust removal.

The above detector may also be a pressure sensor, which is configured for detecting whether a pressure at the first air outlet 43 exceeds a third set value, so as to determine whether the protective mesh 5 needs dust removal. The detector may be arranged inside or outside the first heat dissipation air duct 41. It should be noted that if it is detected that the pressure at the first air outlet 43 exceeds the third set value, it is determined that the protective mesh 5 needs dust removal; and if it is detected that the pressure at the first air outlet 43 does not exceed the third set value, it is determined that the protective mesh 5 does not need dust removal.

In order to remind a user to clean the protective mesh 5, the cabinet assembly further includes an alarm in signal connection with the detector. When the detector detects that the protective mesh 5 needs dust removal, the alarm will be triggered. The alarm may be a sound alarm, a light alarm or other types of alarms.

Based on the cabinet assembly provided in the above embodiments, a photovoltaic power station is further provided according to the present application, as shown in FIG. 28. The photovoltaic power station includes a voltage conversion apparatus 9 and the cabinet assembly as described in the above embodiments, where the conductive member 3 is electrically connected to an input end of the voltage conversion apparatus 9.

The cabinet may be an inverter, and the voltage conversion apparatus 9 may be a medium voltage conversion apparatus, such as a transformer.

Since the cabinet assembly according to the above embodiments has the above technical effects, the photovoltaic power station including the above cabinet assembly also has the corresponding technical effects, which will not be described in detail herein.

Based on the above description of the disclosed embodiments, those skilled in the art are capable of carrying out or using the present application. It is obvious for those skilled in the art to make many modifications to these embodiments. The general principle defined herein may be applied to other embodiments without departing from the scope of the present application.

## Claims

1. A cabinet assembly, comprising at least one cabinet (1), a conductive member (3) and a protective hood assembly (4); wherein
the conductive member (3) is configured to be electrically connected to a cabinet output member (13) of the cabinet (1), and the conductive member (3) is arranged in the protective hood assembly (4);
the protective hood assembly (4) is provided with a first heat dissipation air duct (41), the cabinet (1) is provided with a second heat dissipation air duct (11), and the first heat dissipation air duct (41) is in communication with the second heat dissipation air duct (11) of the at least one cabinet (1) to dissipate heat from the conductive member (3).

2. The cabinet assembly according to claim 1, wherein a second air inlet (14) of the second heat dissipation air duct (11) is in communication with an external environment, a second air outlet (15) of the second heat dissipation air duct (11) is in communication with a first air inlet (42) of the first heat dissipation air duct (41), and a first air outlet (43) of the first heat dissipation air duct (41) is in communication with the external environment.

3. The cabinet assembly according to claim 2, wherein the second heat dissipation air duct (11) and the first heat dissipation air duct (41) are connected to each other in series.

4. The cabinet assembly according to claim 2, wherein the protective hood assembly (4) is located at a bottom end of the cabinet (1), the second air outlet (15) is located at the bottom end of the cabinet (1), and the first air inlet (42) is located at a top end of the protective hood assembly (4).

5. The cabinet assembly according to claim 2, wherein the protective hood assembly (4) is located on a lateral face of the cabinet (1), the second air outlet (15) is located on the lateral face of the cabinet (1) where the protective hood assembly (4) is located, and the first air inlet (42) is located on a lateral face of the protective hood assembly (4) proximate to the cabinet (1).

6. The cabinet assembly according to claim 2, wherein the first air outlet (43) is located on a bottom face or a lateral face of the protective hood assembly (4).

7. The cabinet assembly according to claim 2, wherein the protective hood assembly (4) is located at a bottom end of the cabinet (1), the second air outlet (15) is located at the bottom end of the cabinet (1), the first air inlet (42) is located at a top end of the protective hood assembly (4), and the first air outlet (43) is located on a bottom face or a lateral face of the protective hood assembly (4).

8. The cabinet assembly according to claim 2, wherein the protective hood assembly (4) is located on a lateral face of the cabinet (1), the second air outlet (15) is located on the lateral face of the cabinet (1) where the protective hood assembly (4) is located, the first air inlet (42) is located on a lateral face of the protective hood assembly (4) proximate to the cabinet (1), and the first air outlet (43) is located on a bottom face or another lateral face of the protective hood assembly (4).

9. The cabinet assembly according to claim 2, wherein the first air inlet (42) protrudes from the protective hood assembly (4), the cabinet (1) is provided with a first recess for accommodating the first air inlet (42).

10. The cabinet assembly according to claim 2, wherein
the number of the first air inlet (42) is at least one, and the second heat dissipation air duct (11) corresponds to the at least one first air inlet (42); and/or
the number of the first air outlet (43) is at least one, and the second heat dissipation air duct (11) corresponds to the at least one first air outlet (43).

11. The cabinet assembly according to claim 2, wherein the number of the cabinet (1) is at least two, the number of the second heat dissipation air duct (11) is at least two, and the at least two second heat dissipation air ducts (11) correspond to the same first air outlet (43).

12. The cabinet assembly according to claim 1, wherein the number of the cabinet (1) is at least two, and the at least two cabinets (1) are distributed in sequence along a first direction, wherein the first direction is perpendicular to a vertical direction.

13. The cabinet assembly according to claim 1, wherein the cabinet (1) and the protective hood assembly (4) are hermetically connected to each other at a junction between the second heat dissipation air duct (11) and the first heat dissipation air duct (41).

14. The cabinet assembly according to claim 1, wherein:
the cabinet (1) is provided with a connecting cavity (12), the connecting cavity (12) and the second heat dissipation air duct (11) are isolated from each other, and the cabinet output member (13) is arranged in the connecting cavity (12);
the cabinet assembly further comprises an air duct partition (2) configured for isolating the connecting cavity (12) from the first heat dissipation air duct (41), and the air duct partition (2) is provided with an installation hole for the conductive member (3) or the cabinet output member (13) to pass through.

15. The cabinet assembly according to claim 14, wherein the air duct partition (2) and the protective hood assembly (4) are hermetically connected to each other, to isolate the connecting cavity (12) from the first heat dissipation air duct (41).

16. The cabinet assembly according to claim 14, wherein the protective hood assembly (4) is provided with an installation port (44) configured for the conductive member (3) or the cabinet output member (13) to pass through, and the air duct partition (2) closes the installation port (44); wherein
the installation port (44) and a communication port of the first heat dissipation air duct (41) for communicating with the second heat dissipation air duct (11) are distributed in sequence along a first direction, wherein the first direction is perpendicular to a vertical direction; and/or
the installation port (44) protrudes from the protective hood assembly (4), and the cabinet (1) is provided with a second recess for accommodating the installation port (44).

17. The cabinet assembly according to any one of claims 1 to 16, wherein the first heat dissipation air duct (41) has a first air outlet (43) communicated with an external environment, and the cabinet assembly further comprises a protective mesh (5) provided at the first air outlet (43).

18. The cabinet assembly according to claim 17, wherein the protective mesh (5) is detachably inserted into the protective hood assembly (4), and wherein
the protective hood assembly (4) is provided with a guide rail (45), and the protective mesh (5) is in sliding fit with the guide rail (45); and/or
the protective mesh (5) is provided with a pluggable limiting member (55), a plugging and unplugging direction of the pluggable limiting member (55) is perpendicular to an insertion direction of the protective mesh (5), the protective hood assembly (4) is provided with a limiting hole, and the pluggable limiting member (55) is configured to be in limiting fit with the limiting hole, to limit the protective mesh (5); and/or
the protective mesh (5) is detachably connected to the protective hood assembly (4) by a fastener.

19. The cabinet assembly according to claim 17, further comprising a detector configured to determine whether the protective mesh (5) needs dust removal; wherein
the detector is provided on the conductive member (3), and the detector is configured to determine whether the protective mesh (5) needs dust removal by detecting whether a temperature of the conductive member (3) exceeds a set value; and/or
the cabinet assembly further comprises an alarm being in signal connection with the detector.

20. A photovoltaic power station, comprising a voltage conversion apparatus (9) and the cabinet assembly according to any one of claims 1 to 19, wherein the conductive member (3) is electrically connected to an input end of the voltage conversion apparatus (9).
